(19) Europäisches Patentamt
European Patent Office
Office européen des brevets

(11) **EP 2 684 146 B1**

(12) **FASCICULE DE BREVET EUROPEEN**

(45) Date de publication et mention
de la délivrance du brevet:
**11.02.2015 Bulletin 2015/07**

(51) Int Cl.:
***G06F 17/50*** *(2006.01)*

(21) Numéro de dépôt: **12708322.8**

(22) Date de dépôt: **09.03.2012**

(86) Numéro de dépôt international:
**PCT/EP2012/054157**

(87) Numéro de publication internationale:
**WO 2012/120133 (13.09.2012 Gazette 2012/37)**

(54) **PROCEDE D'ESTIMATION DE L'ETANCHEITE D'UN JOINT**

VERFAHREN ZUR BERECHNUNG DER DICHTIGKEIT EINER DICHTUNG

METHOD TO ESTIMATE THE TIGHTNESS OF A GASKET

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **10.03.2011 FR 1151964**

(43) Date de publication de la demande:
**15.01.2014 Bulletin 2014/03**

(73) Titulaires:
• **Commissariat à l'Énergie Atomique
et aux Énergies Alternatives
75015 Paris (FR)**
• **Association pour la Recherche et le
Développement
des Méthodes et Processus Industriels
75006 Paris (FR)**

(72) Inventeurs:
• **PEIGAT, Laurent
16800 SOYAUX FRANCE (FR)**
• **BESSON, Jacques
F-77920 Samois-sur-Seine (FR)**
• **REYTIER, Magali
38250 VILLARD DE LANS FRANCE (FR)**

(74) Mandataire: **Ilgart, Jean-Christophe
BREVALEX
95, rue d'Amsterdam
75378 Paris Cedex 8 (FR)**

(56) Documents cités:
• **ANIKEENKO V A ET AL: "Leak tightness of
detachable joints with heat-expanded graphite
gaskets", CHEMICAL AND PETROLEUM
ENGINEERING, KLUWER ACADEMIC
PUBLISHERS-CONSULTANTS BUREAU, NE, vol.
43, no. 11-12, 1 novembre 2007 (2007-11-01),
pages 740-743, XP019570684, ISSN: 1573-8329**
• **SNIPPE C H C ET AL: "Prediction of Gas Leak
Tightness of Superplastically Formed Products",
AIP CONFERENCE PROCEEDINGS AMERICAN
INSTITUTE OF PHYSICS USA, vol. 1252, 2010,
pages 818-825, XP002666852, ISSN: 0094-243X**
• **H ZERRES: "Present calculation methods
dedicated to bolted flanged connections",
INTERNATIONAL JOURNAL OF PRESSURE
VESSELS AND PIPING, vol. 81, no. 2, 1 février
2004 (2004-02-01), pages 211-216, XP055016100,
ISSN: 0308-0161, DOI: 10.1016/j.ijpvp.
2003.11.011**
• **MARIE C ET AL: "Experimental leak-rate
measurement through a static metal seal",
TRANSACTIONS OF THE ASME. JOURNAL OF
FLUIDS ENGINEERING ASME USA, vol. 129, no.
6, juin 2007 (2007-06), pages 799-805,
XP009155330, ISSN: 0098-2202**
• **MARIE C ET AL: "An integrated approach to
characterize liquid leakage through metal contact
seal", EUROPEAN JOURNAL OF MECHANICAL
AND ENVIRONMENTAL ENGINEERING JUNE
2003 BELGIAN SOC. OF MECHANICAL AND
ENVIRON. ENGINEERING BE, vol. 48, no. 2, juin
2003 (2003-06), pages 81-86, XP009155329,**

## Description

## DOMAINE TECHNIQUE

L'invention concerne un procédé d'estimation de l'étanchéité d'un joint. Ce procédé s'applique notamment pour tous les joints utilisés à haute température, et sera particulièrement avantageux pour estimer l'étanchéité de joints destinés à être utilisés dans un électrolyseur à haute température (EHT), entre une cellule électrochimique et un interconnecteur métallique de l'électrolyseur.

## ÉTAT DE LA TECHNIQUE ANTÉRIEURE

Un électrolyseur à haute température est un système électrochimique visant à produire de l'hydrogène à partir d'une électrolyse de vapeur d'eau réalisée à une température comprise entre environ 600°C et 1000°C. Il est constitué notamment de cellules électrochimiques, généralement en céramique, et d'interconnecteurs métalliques empilés. Des espaces formés entre les cellules et les interconnecteurs forment des chambres contenant des gaz (hydrogène et oxygène) issus de la réaction d'électrolyse. Afin d'éviter une recombinaison entre l'hydrogène et l'oxygène formés, pouvant se produire lorsque ces gaz se mélangent, et éviter également les fuites de ces gaz vers l'extérieur, il est nécessaire que ces chambres soient étanches.

Un tel électrolyseur de type EHT a pour avantage de ne pas induire d'émission de $CO_2$ et présente un rendement théoriquement meilleur que celui d'un électrolyseur traditionnel à basse température, une partie de l'énergie nécessaire à l'électrolyse étant apportée sous forme de chaleur et non uniquement sous la forme d'électricité.

Un objectif de cette technologie est de réaliser des électrolyseurs couplés à des sources thermiques d'origine nucléaire, géothermique ou encore solaire. Toutefois, la gestion des gaz (vapeur d'eau, hydrogène et oxygène) et le maintien de l'étanchéité dans le temps sont des problèmes majeurs pour la réalisation de tels électrolyseurs. En effet, les étanchéités doivent être réalisées entre des matériaux de natures différentes (céramique et métal) et être efficaces à haute température. Or, une cellule électrochimique en céramique est fragile et possède un coefficient de dilatation thermique significativement inférieur à celui d'un interconnecteur métallique. Les liaisons étanches à réaliser doivent donc être réalisées sous faible charge de manière à ne pas trop solliciter mécaniquement la cellule électrochimique, être suffisamment souples pour encaisser le différentiel de dilatation, et aussi présenter une bonne tenue au fluage pour garantir le maintien de l'étanchéité dans la durée à haute température.

Les solutions de référence pour réaliser une telle étanchéité dans un électrolyseur EHT consistent à utiliser des joints à base de verre à l'état pâteux. Toutefois, l'utilisation de ce type de joint présente un certain nombre d'inconvénients. En effet, bien que pendant le fonctionnement nominal de l'électrolyseur les propriétés de ces joints soient généralement bien adaptées, des problèmes apparaissent durant les régimes transitoires, c'est-à-dire lors des phases de chauffage et de refroidissement. En effet, un joint verre est fragile en dessous de sa température de transition vitreuse et est susceptible de se rompre s'il est sollicité à une telle température, notamment à cause des dilatations différentielles apparaissant entre les interconnecteurs et les cellules électrochimiques. Un tel joint crée alors une liaison rigide entre les éléments de l'électrolyseur, générant des contraintes lors des régimes transitoires thermiques. De plus, lorsque les étanchéités sont réalisées par de tels joints, le démontage des composants de la cellule est difficile, voire impossible, sans changer complètement la cellule. La disposition verticale de tels joints peut également poser des problèmes car le verre peut alors s'écouler, réduire la durée de vie de l'assemblage, et ne pas supporter les pressions de quelques bars régnant dans un électrolyseur à haute température industriel. Enfin, les verres utilisés pour réaliser ces joints peuvent ne pas être compatibles chimiquement avec les autres composants de la cellule et de l'interconnecteur, ce qui peut entrainer une corrosion importante des portées de joints ou encore une pollution au silicium des électrodes de l'EHT.

Une autre solution pour réaliser l'étanchéité entre les cellules en céramique et les interconnecteurs métalliques consiste à braser le métal de l'interconnecteur directement sur la céramique.

Toutefois, l'obtention du mouillage de l'interconnecteur sur la céramique ainsi que les différences de dilatation thermique entre ces éléments rendent cette opération très difficile, notamment lorsqu'elle réalisée sur des éléments de grandes dimensions, le refroidissement après la solidification de la brasure provoquant généralement la rupture de la céramique si aucune souplesse dans la structure de l'interconnecteur n'est introduite.

Il est également connu d'utiliser d'autres types de joints compressifs à base de mica ou simplement métalliques. Toutefois, de tels joints nécessitent un serrage extérieur à contrôler et à maintenir en température pour obtenir une étanchéité efficace sans rupture de la cellule en cours de chauffage. Il existe donc un besoin pour améliorer ces joints compressifs en vue d'améliorer l'étanchéité entres les cellules en céramique et les interconnecteurs métalliques d'un électrolyseur EHT.

Un procédé connu pour estimer l'étanchéité d'un joint en fonction des paramètres du joint est divulgué dans "Present calculation methods dedicated to bolted flanged connections", H. Zerres, International Journal of Pressure Vessels and Piping, Volume 81, pages 211-216.

## EXPOSÉ DE L'INVENTION

Un but de la présente invention est de proposer un procédé permettant d'estimer a priori, par calcul, l'étanchéité d'un joint, afin de pouvoir optimiser la structure de ce joint sans avoir à mesurer réellement cette étanchéité à chaque modification de la structure du joint.

Pour cela, il est proposé un procédé d'estimation de l'étanchéité d'un joint comme décrit dans revendication 1.

Ce procédé permet d'estimer a priori la qualité d'étanchéité d'un joint et de son maintien dans le temps à partir notamment des caractéristiques géométriques du joint. Ainsi, il est possible de développer et qualifier de nouveaux joints, par exemple métalliques pour un électrolyseur à haute température, et vérifier si l'étanchéité obtenue permet d'obtenir une fuite acceptable, par exemple inférieure ou égale à environ $10^{-3}$ Nml/min/mm dans le cas d'un joint pour électrolyseur à haute température, sans nécessiter la mise en oeuvre d'essais et de mesures sur le joint. Ce procédé permet notamment de proposer de nouvelles solutions d'étanchéité pour un électrolyseur haute température en établissant un cahier des charges que devrait remplir un joint pour avoir une fuite la plus faible possible, la fuite étant minimisée lorsque l'on cherche à maximiser le terme $F_{num}$.

Le comportement mécanique du joint et des portées pourra être identifié afin de mener les simulations. Le joint peut avoir un comportement viscoplastique et peut se déformer par fluage entre les deux portées dont le comportement peut être élastique.

Le terme « portées » est ici utilisé pour désigner les éléments entre lesquels le joint est destiné à être disposé. Par exemple, dans le cas d'un EHT, ces deux portées correspondront à une cellule en céramique et à un interconnecteur métallique.

Le procédé peut comporter en outre, après l'étape de calcul du coefficient de bouchage de porosités simulé $F_{num}$, une étape de calcul d'un débit massique de fuite simulé $Q_{mnum}$ d'un fluide au sein d'un espace étanchéifié par le joint, tel que :

$$Q_{mnum} = \frac{\pi.M}{\mu.R.T.F_{num}}\left(Pe^2 - Pi^2\right),$$

avec

    $M$ : masse molaire du fluide, en kg/mol
    $\mu$ : viscosité dynamique du fluide, en Pa.s
    $R = 8{,}314$ J/K/mol
    $T$ : température du fluide, en K
    $Pi$ : pression dans l'espace étanchéifié, en Pa
    $Pe$ : pression hors de l'espace étanchéifié, en Pa.

Le procédé peut comporter en outre, lorsque les valeurs des coefficients $\lambda$, $\alpha$ et $\beta$ sont inconnues pour le matériau du joint, une détermination des valeurs des coefficients $\lambda$, $\alpha$ et $\beta$ correspondant au matériau du joint obtenue en réalisant les étapes suivantes :

- mesure d'un débit massique $Q_m$ d'un fluide permettant de maintenir ce fluide à une pression $Pi$ sensiblement constante dans un espace étanchéifié par un second joint comportant ledit matériau au cours d'une déformation par fluage du second joint par écrasement du second joint entre deux portées,
- calcul d'un coefficient de bouchage de porosités expérimental $F_{exp}$, représentatif de l'étanchéité du second joint à au moins une interface entre le second joint et une des deux portées, tel que :

$$F_{exp} = \frac{\pi.M}{\mu.R.T.Q_m}\left(Pe^2 - Pi^2\right),$$

avec

    $M$ : masse molaire du fluide, en kg/mol

$\mu$ : viscosité dynamique du fluide, en Pa.s

$R$ = 8,314 J/K/mol

$T$ : température du fluide, en K

$Q_m$ : débit massique du fluide, en kg/s

$Pi$ : pression dans l'espace étanchéifié, en Pa

$Pe$ : pression hors de l'espace étanchéifié, en Pa,

et, après le calcul du coefficient de bouchage de porosités simulé $F_{num}$, une étape de calcul des valeurs des coefficients $\lambda$, $\alpha$ et $\beta$ réalisée par minimisation de l'écart entre les valeurs de $F_{num}$ et $F_{exp}$.

Ainsi, lorsque les coefficients $\lambda$, $\alpha$ et $\beta$ sont inconnus pour le matériau du joint, on relie un taux de fuite d'un second joint à base d'un matériau similaire, mesuré expérimentalement, à des paramètres mécaniques locaux (déformation plastique cumulée et contrainte axiale) calculés numériquement afin de pouvoir déterminer ces coefficients. Ces coefficients pourront alors servir à estimer a priori la qualité d'étanchéité d'un joint, quelque soit sa forme, et de son maintien dans le temps à partir d'un design et de simulations numériques, sans avoir à réaliser des mesures expérimentales.

L'étape de calcul des valeurs des coefficients $\lambda$, $\alpha$ et $\beta$ peut être réalisée en minimisant l'écart entre $F_{num}$ et $F_{exp}$, par exemple en appliquant la méthode des moindres carrés.

Le procédé peut comporter en outre, préalablement à la mise en oeuvre de la déformation par fluage du second joint et lorsque le second joint est composé d'au moins un matériau métallique, une étape d'oxydation thermique du second joint. Une telle oxydation thermique permet d'améliorer la tenue du second joint au fluage et de faciliter le démontage du second joint après la déformation en formant une couche d'alumine autour du second joint.

L'étape de mesure du débit massique $Q_m$ peut être obtenue en réalisant :

- une première étape de montée en température du second joint et des portées,
- une deuxième étape de mise en contact et de mise en pression des portées contre le second joint,
- une troisième étape de maintien de la pression exercée par les portées contre le second joint,
- une quatrième étape de réduction de la pression exercée par les portées contre le second joint,
- une cinquième étape de séparation d'au moins une des portées et du second joint.

La première étape de montée en température peut être mise en oeuvre jusqu'à atteindre une température comprise entre environ 600°C et 1000°C, et/ou dans lequel la pression exercée par les portées sur le second joint lors de la troisième étape peut correspondre à un effort exercé par au moins l'une des portées sur le second joint compris entre environ 3 N/mm et 10 N/mm, et/ou dans lequel la troisième étape de maintien de la pression exercée par les portées sur le second joint peut être mise en oeuvre pendant une durée comprise entre environ 5 heures et 15 heures.

Lors de la déformation par fluage du second joint, une première face du second joint peut être disposée contre une des portées formant un support, la pression entre un bossage et le joint étant appliquée par l'autre portée en contact avec une seconde face, opposée à la première face, du joint, au moins l'une des portées étant mobile.

L'étape de simulation numérique peut être mise en oeuvre par l'intermédiaire d'un logiciel de calcul mécanique par éléments finis.

Le procédé peut comporter en outre, préalablement à l'étape de simulation numérique, une étape de mesure par profilométrie laser du profil du joint et/ou des portées, un maillage numérique du joint et/ou des portées, utilisé au cours de l'étape de simulation numérique, étant réalisé à partir du profil mesuré du joint et/ou des portées. Ainsi, il est possible de mailler la géométrie au plus proche de la réalité en contrôlant celle-ci par profilométrie laser.

La déformation plastique cumulée $p$ et la contrainte axiale $Smzz$ peuvent être calculées au cours de la simulation numérique à des points de Gauss d'éléments d'un maillage numérique du joint et des portées, les valeurs calculées de la déformation plastique cumulée $p$ et de la contrainte axiale $Smzz$ étant moyennées et ramenées à des noeuds du joint.

La longueur de contact $Lc$ peut être obtenue en calculant, par extrapolation polynômiale de la contrainte axiale $Smzz$ exprimée en fonction d'une position au niveau de ladite interface entre le joint et ladite une des deux portées, les valeurs de deux abscisses correspondant à la valeur maximale divisée par 10 de la contrainte axiale maximale $Smzz$, la longueur de contact $Lc$ correspondant à la différence entre lesdites valeurs des deux abscisses.

La déformation plastique cumulée et la contrainte axiale peuvent être calculées le long du contact entre le joint et au moins une des deux portées.

L'invention concerne également un dispositif d'estimation de l'étanchéité d'un joint, comportant des moyens aptes à mettre en oeuvre un procédé d'estimation de l'étanchéité d'un joint tel que défini précédemment.

Il est également proposé un dispositif d'estimation de l'étanchéité d'un joint, comportant au moins :

- des moyens de simulation numérique d'une déformation par fluage du joint par écrasement du joint entre deux portées,

- des moyens de calcul, à au moins une interface entre le joint et l'une des deux portées, d'une déformation plastique cumulée *p* du joint, d'une contrainte axiale *Smzz* entre le joint et ladite une des deux portées, et d'une longueur de contact *Lc* entre le joint et ladite une des deux portées, au cours de la simulation numérique,
- des moyens de calcul d'un coefficient de bouchage de porosités simulé $F_{num}$, représentatif de l'étanchéité du joint à ladite interface entre le joint et ladite une des deux portées, tel que :

$$F_{num} = \int_{ri}^{re} \int_{p} \lambda . \left( \frac{Smzz}{\sigma_{seuil}} \right)^{\alpha} . \left( \frac{p}{p_0} \right)^{\beta} dp \frac{dr}{r} \, ,$$

avec

$\lambda$, $\alpha$ et $\beta$ : coefficients dont les valeurs dépendent du matériau du joint
*Lc = re - ri*, en m
*Smzz* : contrainte axiale, en MPa
$\sigma_{seuil}$ : contrainte seuil égale à 1 MPa
*p* : déformation plastique cumulée
$p_0$ : constante égale à 1.

Le dispositif peut comporter en outre des moyens de calcul d'un débit massique de fuite simulé $Q_{mnum}$ d'un fluide au sein d'un espace étanchéifié par le joint, tel que :

$$Q_{mnum} = \frac{\pi . M}{\mu . R . T . F_{num}} \left( Pe^2 - Pi^2 \right),$$

avec

*M* : masse molaire du fluide, en kg/mol
$\mu$ : viscosité dynamique du fluide, en Pa.s
*R* = 8,314 J/K/mol
*T* : température du fluide, en K
*Pi* : pression dans l'espace étanchéifié, en Pa
*Pe* : pression hors de l'espace étanchéifié, en Pa.

Le dispositif peut comporter en outre, lorsque les valeurs des coefficients $\lambda$, $\alpha$ et $\beta$ sont inconnues pour le matériau du joint, des moyens de détermination des valeurs des coefficients $\lambda$, $\alpha$ et $\beta$ du matériau du joint comportant :

- des moyens de déformation par fluage par écrasement d'un second joint entre deux portées,
- des moyens de mesure d'un débit massique $Q_m$ d'un fluide permettant de maintenir ce fluide à une pression *Pi* sensiblement constante dans un espace étanchéifié par un second joint comportant ledit matériau au cours d'une déformation par fluage du second joint par écrasement du second joint entre deux portées,
- des moyens de calcul d'un coefficient de bouchage de porosités expérimental $F_{exp}$, représentatif de l'étanchéité du second joint à au moins une interface entre le second joint et une des deux portées, tel que :

$$F_{exp} = \frac{\pi . M}{\mu . R . T . Q_m} \left( Pe^2 - Pi^2 \right),$$

avec

$M$ : masse molaire du fluide, en kg/mol

$\mu$ : viscosité dynamique du fluide, en Pa.s

$R$ = 8,314 J/K/mol

$T$ : température du fluide, en K

$Q_m$ : débit massique du fluide, en kg/s

$Pi$ : pression dans l'espace étanchéifié, en Pa

$Pe$ : pression hors de l'espace étanchéifié, en Pa,

- des moyens de calcul des valeurs des coefficients $\lambda$, $\alpha$ et $\beta$ aptes à minimiser l'écart entre les valeurs des coefficients $F_{num}$ et $F_{exp}$.

Le dispositif peut comporter en outre des moyens de simulation numérique par éléments finis du joint et des portées, comprenant par exemple un logiciel de calcul mécanique par éléments finis.

L'invention concerne également un produit programme d'ordinateur mémorisant un code exécutable pour la mise en oeuvre d'un procédé d'estimation de l'étanchéité d'un joint tel que décrit précédemment.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente un dispositif de mesure d'une fuite depuis un espace étanchéifié par un joint, pouvant être utilisé au cours d'un procédé d'estimation de l'étanchéité d'un joint, objet de la présente invention, selon un mode de réalisation particulier,
- la figure 2 est une vue en coupe d'un joint disposé entre deux portées d'un dispositif de mesure de fuite pouvant être utilisé au cours d'un procédé d'estimation de l'étanchéité d'un joint, objet de la présente invention, selon un mode de réalisation particulier,
- la figure 3 représente les profils de différents bossages pouvant être utilisés lors d'un procédé d'estimation de l'étanchéité d'un joint, objet de la présente invention, selon un mode de réalisation particulier,
- les figures 4 à 10 représentent des taux de fuite mesurés au cours d'une déformation par fluage d'un joint par les différents bossages représentés sur la figure 3 et pour différents efforts appliqués sur le joint lors de la déformation,
- la figure 11 représente un maillage numérique d'un joint et de deux portées réalisé au cours d'un procédé d'estimation de l'étanchéité d'un joint, objet de la présente invention, selon un mode de réalisation particulier,
- les figures 12 et 13 représentent la répartition de la contrainte axiale et de la déformation plastique cumulée calculées lors de la simulation numérique réalisée au cours d'un procédé d'estimation de l'étanchéité d'un joint, objet de la présente invention, selon un mode de réalisation particulier,
- la figure 14 représente la contrainte axiale calculée au cours de la simulation numérique d'un procédé d'estimation de l'étanchéité d'un joint, objet de la présente invention, selon un mode de réalisation particulier,
- les figures 15 à 18 représentent des taux de fuite mesurés au cours d'une déformation par fluage d'un joint par les différents bossages représentés sur la figure 3 et pour différents efforts appliqués sur le joint lors de la déformation, en fonction de la déformation plastique cumulée moyenne et de la longueur de contact calculées,
- la figure 19 représente des valeurs de $F_{num}$ et $F_{exp}$ obtenues lors de la mise en oeuvre d'un procédé d'estimation de l'étanchéité d'un joint, objet de la présente invention,
- la figure 20 représente un dispositif d'estimation de l'étanchéité d'un joint, également objet de la présente invention, comportant des moyens aptes à mettre en oeuvre un procédé d'estimation de l'étanchéité d'un joint, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

Les fuites que l'on cherche à réduire au sein d'un électrolyseur EHT, qui correspondent à un écoulement de gaz depuis l'intérieur de l'espace étanchéifié du joint vers l'extérieur de cet espace, correspondent à des écoulements d'un fluide à travers des porosités. Ces porosités présentes à l'interface entre le joint et la cellule électrochimique et/ou entre le joint et l'interconnecteur métallique de l'électrolyseur EHT, sont formées par les rugosités présentes à l'interface de ces éléments.

Le nombre de Reynolds Re est un nombre adimensionnel caractérisant un écoulement d'un fluide, en particulier la nature de son régime (laminaire, transitoire ou turbulent), et représentant le rapport entre les forces d'inertie et les forces visqueuses de cet écoulement. Ce nombre de Reynolds Re est défini par l'équation suivante :

$$Re = \frac{\rho SL}{\mu} = \frac{SL}{\nu} \qquad (1)$$

avec

$\rho$ : masse volumique du fluide, en kg/m$^3$
$S$ : vitesse du fluide, en m/s
$L$ : longueur caractéristique, en m
$M$ : viscosité dynamique du fluide, en Pa.s

$\nu = \dfrac{\mu}{\rho}$ : viscosité cinématique du fluide, en m$^2$/s.

Dans les conditions rencontrées dans l'électrolyseur, à savoir que le fluide considéré est de l'air, que la température est égale à environ 800°C et que la pression est égale à environ 1,2 bar, et en prenant une vitesse de fluide de 1 m/s et une longueur de contact de 1.10$^{-4}$ m, le nombre de Reynolds Re est égal à 0,763, ce qui correspond à un écoulement de type laminaire.

Pour ce type d'écoulement, sous des conditions stationnaires (les variables étant indépendantes du temps), l'écoulement d'un fluide à travers un milieu poreux est décrit par la loi de Darcy.

Dans le cas d'un écoulement radial, la loi de Darcy pour un gaz est :

$$Q_m = \frac{A\rho k}{\mu}\frac{dP}{dr} \qquad (2)$$

avec

$Q_m$ : débit massique, en kg/s
$A$ : surface de la section de passage, en m$^2$
$\rho$ : masse volumique, en kg/m$^3$
$k$ : perméabilité intrinsèque du milieu poreux, en m$^2$
$\mu$ : viscosité dynamique, en Pa.s

$\dfrac{dP}{dr}$ : gradient de pression radial, en Pa/m.

Lorsque le fluide est compressible, ce qui est le cas de l'air, la loi des gaz parfaits s'applique :

$$PV = nRT = \frac{mRT}{M} \qquad (3)$$

avec

$P$ : pression, en Pa
$V$ : volume du fluide, en m$^3$

$N$ : quantité de matière, en mol
$R$ : constante des gaz parfaits ($R$ = 8.314 J/K/mol)
$T$ : température du fluide, en K
$m$ : masse du fluide, en kg
$M$ : masse molaire, en kg/mol.

On a donc :

$$\rho = \frac{MP}{RT} \qquad (4)$$

A partir des équations (2) et (4) ci-dessus, il est possible d'écrire l'équation suivante :

$$\frac{Q_m RT \rho}{MP} = \frac{A\rho k}{\mu} \frac{dP}{dr} \qquad (5)$$

Or, la surface A peut s'écrire :

$$A = 2\pi r h \qquad (6)$$

Avec

$r$ : rayon du pore, en m
$h$ : hauteur caractéristique, en m.

A partir des équations (5) et (6) ci-dessus, il est donc possible d'écrire :

$$Q_m \frac{dr}{r} = \frac{2\pi M}{\mu RT} hk\, P dP \qquad (7)$$

Le terme $\dfrac{2\pi M}{\mu RT} = \delta$ est indépendant de la pression. Le terme $hk$ dépend de r puisqu'il varie selon la longueur de contact, et sera noté $\kappa(r)$ par la suite.

Pour déterminer le débit massique de fuite entre l'intérieur et l'extérieur de l'espace étanchéifié par le joint au niveau d'une interface avec le joint, on intègre l'équation (7) en prenant en compte les conditions limites de ces deux milieu :

$$Q_m \int_{r_i}^{r_e} \frac{dr}{\kappa(r)r} = \delta \int_{P_i}^{P_e} P dP \qquad (8)$$

Ou encore :

$$Q_m \int_{r_i}^{r_e} \frac{dr}{\kappa(r)r} = \frac{\delta}{2}\left(P_e^2 - P_i^2\right) \qquad (9)$$

avec

$r_e$ et $r_i$ : rayons extérieur et intérieur de la déformation du joint, en m (et avec $r_e$ - $r_i$ = *longueur de contact).*

$P_e$ et $P_i$ : pressions intérieures et extérieure de l'espace étanchéifié par le joint, en Pa.

Le débit de fuite radial analytique selon la loi de Darcy s'exprime alors en fonction d'une différence des carrés des pressions entre deux milieux, de paramètres géométriques du dispositif considéré ainsi que de paramètres liés au fluide étudié.

L'équation (9) précédente peut également s'écrire sous la forme :

$$\int_{r_i}^{r_e} \frac{dr}{\kappa(r)r} = \frac{\delta}{2Q_m}\left(P_e^2 - P_i^2\right) \qquad (10)$$

Plus le milieu est perméable, plus le fluide peut s'écouler facilement et plus la fuite est importante. De même, plus la hauteur des pores (ou trous) est importante, plus la fuite le sera aussi.

Dans l'équation (10) ci-dessus, le terme $\kappa(r)$ contient les termes de perméabilité et de hauteur de pore favorisant la fuite. Par conséquent, lorsque le terme $\dfrac{1}{\kappa(r)}$ augmente, cela signifie que la fuite diminue et que les porosités facilitant le passage du fluide sont peu à peu bouchées. L'équation (10) correspond alors à un coefficient de bouchage de porosités au niveau de l'interface avec le joint et sera noté $F_{exp}$ tel que :

$$F_{exp} = \int_{r_i}^{r_e} \frac{dr}{\kappa(r)r} = \frac{\delta}{2Q_m}\left(P_e^2 - P_i^2\right) \qquad (11)$$

On décrit maintenant un procédé d'estimation de l'étanchéité d'un joint destiné à être utilisé par exemple dans un électrolyseur de type EHT, entre une cellule électrochimique et un interconnecteur métallique de cet électrolyseur.

Afin de pouvoir déterminer un coefficient de bouchage de porosités simulé $F_{num}$ représentatif de l'étanchéité du joint que l'on cherche à estimer, il est nécessaire de connaitre des coefficients $\lambda$, $\alpha$ et $\beta$ propres au matériau du joint. Dans l'exemple décrit ici, ces coefficients sont inconnus. Pour déterminer ces coefficients, on réalise préalablement au calcul de coefficient de bouchage de porosités simulé $F_{num}$ une mesure expérimentale du taux de fuite d'un second joint 10, composé du même matériau que celui du joint dont on cherche à caractériser l'étanchéité, ce taux de fuite correspondant au débit massique $Q_m$ d'un fluide s'échappant depuis l'intérieur d'un volume étanchéifié par le second joint vers l'extérieur de ce volume, à travers les porosités formées par les rugosités aux interfaces du second joint 10.

A partir de ce taux de fuite mesuré, il sera possible de calculer un coefficient de bouchage de porosités expérimental $F_{exp}$. Ce coefficient de bouchage de porosités expérimental $F_{exp}$ sera alors utilisé pour déterminer des coefficients A, $\alpha$ et $\beta$ propres au matériau du joint qui pourront ensuite servir à estimer a priori, c'est-à-dire par calcul, sans avoir à réaliser des mesures expérimentales de taux de fuite, l'étanchéité de n'importe quel joint composé du même matériau que celui du second joint 10, à partir d'un calcul du coefficient de bouchage de porosités simulé $F_{num}$.

Le joint dont on cherche à estimer par calcul l'étanchéité peut avoir une forme quelconque. Il peut notamment présenter des parties saillantes, ou bossages, contribuant à réaliser l'étanchéité notamment lorsque les parties entre lesquelles le joint est destiné à réaliser l'étanchéité (ces parties correspondant par exemple à une cellule électrochimique et à un interconnecteur métallique d'un électrolyseur EHT) présentent des surfaces destinées à être en contact avec le joint relativement planes. Le second joint 10 utilisé au cours de la phase de mesure expérimentale du procédé peut donc avoir une forme similaire ou non à celle du joint dont on cherche à caractériser l'étanchéité.

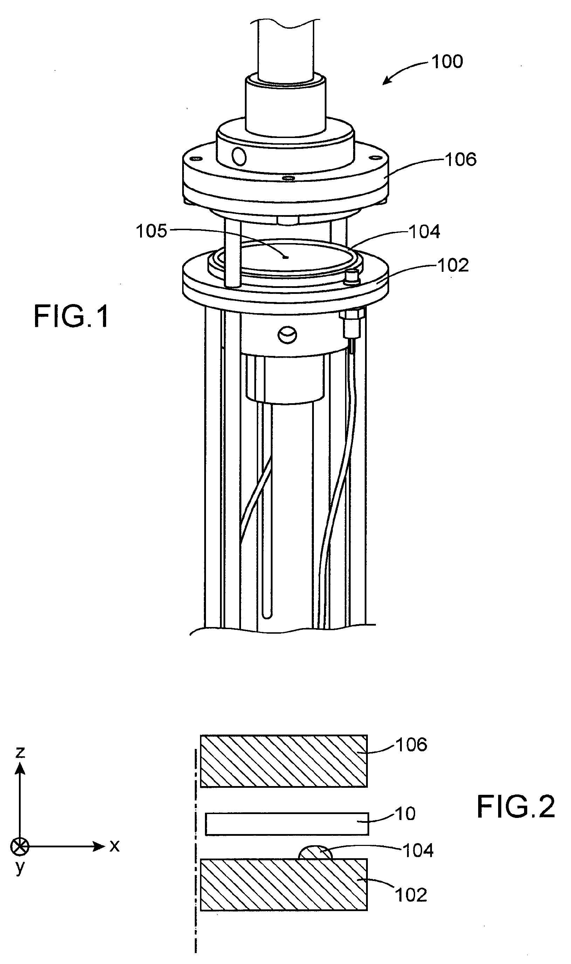

Les mesures sont réalisées par un dispositif de mesure 100, représenté sur la figure 1, permettant de mesurer une fuite depuis l'espace étanchéifié par le second joint 10 en fonction d'un effort linéique appliqué sur le second joint 10 et de l'écrasement de celui-ci.

Le dispositif de mesure 100 comporte une portée inférieure 102 servant de support sur lequel le second joint 10 est destiné à reposer. Cette portée inférieure 102 peut comporter un bossage 104 destiné à déformer le second joint 10 par fluage lorsque celui-ci sera pressé contre ce bossage 104. Le dispositif 100 comporte également une portée supérieure 106 destinée à venir presser le second joint 10 contre le bossage 104 afin que ce dernier déforme par fluage le second joint 10.

La figure 2 représente une vue en coupe du second joint 10 disposé entre les deux portées 102 et 106, ainsi que le profil du bossage 104. Vu de dessus, c'est-à-dire dans le plan (X, Y) selon les axes X, Y et Z représentés sur la figure 2, le bossage 104 est de forme sensiblement circulaire, l'espace étanchéifié par le second joint 10 correspondant à l'espace à l'intérieur du cercle délimité par le bossage 104, entre le second joint 10 et la porté inférieure 102.

Le dispositif de mesure 100 est ici associé à un four sous air permettant d'effectuer les mesures jusqu'à une température égale à environ 1000°C.

Le taux de fuite mesuré correspond au débit de gaz, par exemple de l'air, nécessaire au maintien d'une surpression, sensiblement constante et par exemple égale à environ 200 mbar, dans la zone étanchéifiée par le second joint 10. Le fluide sort par un orifice 105 formé à travers la portée inférieure 102 au niveau de l'espace destiné à être étanchéifié. Le dispositif 100 comporte des moyens de régulation du débit du fluide permettant de maintenir cette surpression sensiblement constante. La fuite se produit à travers les porosités formées par les rugosités du second joint 10 et celles du bossage 104, rugosités qui forment un milieu poreux dont la configuration varie au cours du temps, le second joint 10 venant combler certaines de ces rugosités lors de son fluage.

Le dispositif 100 permet de contrôler la pression au sein de l'espace étanchéifié, l'écrasement du joint et l'effort appliqué sur le joint au cours de l'essai.

Le second joint 10 est par exemple un feuillard composé de fecralloy (alliage composé de fer, de chrome et d'aluminium). Le joint dont on cherche à estimer par calcul l'étanchéité est également composé de fecralloy. Dans une variante, le joint dont on cherche à estimer par calcul l'étanchéité ainsi que le second joint 10 pourraient être composés d'argent.

Les portées 102 et 106 comportent par exemple un alliage à base de nickel, par exemple de type Udimet 720. Dans l'EHT, le joint est par exemple destiné à être disposé entre des éléments composés d'acier de type Crofer, d'Udimet, d'alliage de type Haynes 230 ou encore de zircone.

Afin d'illustrer les calculs réalisés par la suite au cours du procédé, les mesures vont être réalisées en déformant par fluage plusieurs joints à partir de différents bossages et avec différents efforts appliqués sur les joints.

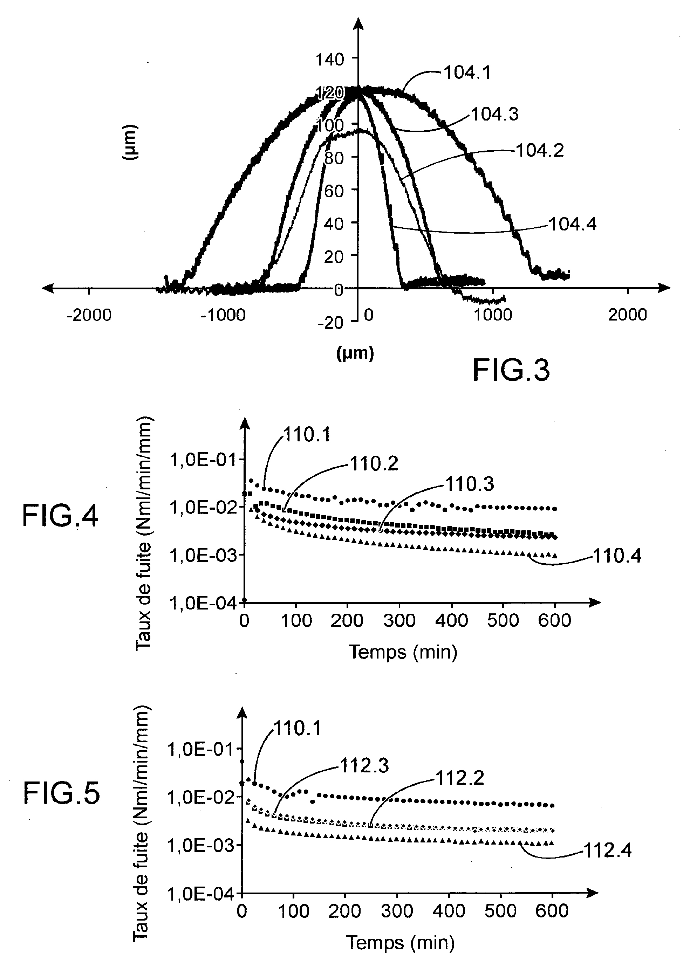

La figure 3 représente les profils de différents bossages 104.1, 104.2, 104.3 et 104.4 utilisés pour réaliser une déformation par fluage de plusieurs seconds joints 10. Ces profils sont ici mesurés précisément par profilométrie laser.

Les seconds joints 10 sont d'abord préoxydés au cours d'un traitement thermique d'environ 30h à environ 900°C afin d'améliorer leur tenue au fluage et de faciliter le démontage après la déformation en formant une couche d'alumine autour du joint.

La procédure expérimentale de déformation par fluage des joints dans le dispositif de mesure 100 est ensuite mise en oeuvre. Pour cela, un des seconds joints 10 est déposé dans l'enceinte du four du dispositif 100, entre les portées 102 et 106, puis la température est montée jusqu'à environ 800°C avec une rampe d'environ 5°C/min.

Une fois cette température atteinte, la portée supérieure 106 est amenée au contact du second joint 10 puis de l'air est envoyé dans le circuit de gaz. La séquence de serrage destinée à déformer le second joint par fluage est ensuite lancée. L'effort, correspondant à la force exercée par la portée supérieure 106 sur le second joint 10, est augmenté jusqu'à une valeur cible pendant environ 50 secondes.

Cet effort est ensuite maintenu pendant environ 10 h, puis réduit jusqu'à redevenir nul pendant environ 50 secondes. Plusieurs essais ont été effectués avec les différents bossages 104.1 à 104.4, avec des efforts égaux à 3, 5 et 10 N/mm. La fuite, l'écrasement du joint et l'effort sont suivis et mesurés tout au long des différentes phases de la déformation.

Les valeurs des efforts appliqués sur le second joint sont fonction de l'application envisagée et des gammes de fuite étudiées. Ainsi, pour des joints destinés à réaliser une étanchéité au sein d'un électrolyseur EHT sous faible charge, des efforts allant de 3 à 10 N/mm sont pertinents pour obtenir un taux de fuite correspondant à environ 1 % de l'hydrogène produit, soit environ $10^{-3}$ Nml/min/mm. Le pourcentage d'erreur sur le taux de fuite mesuré est inférieur à environ 10 %.

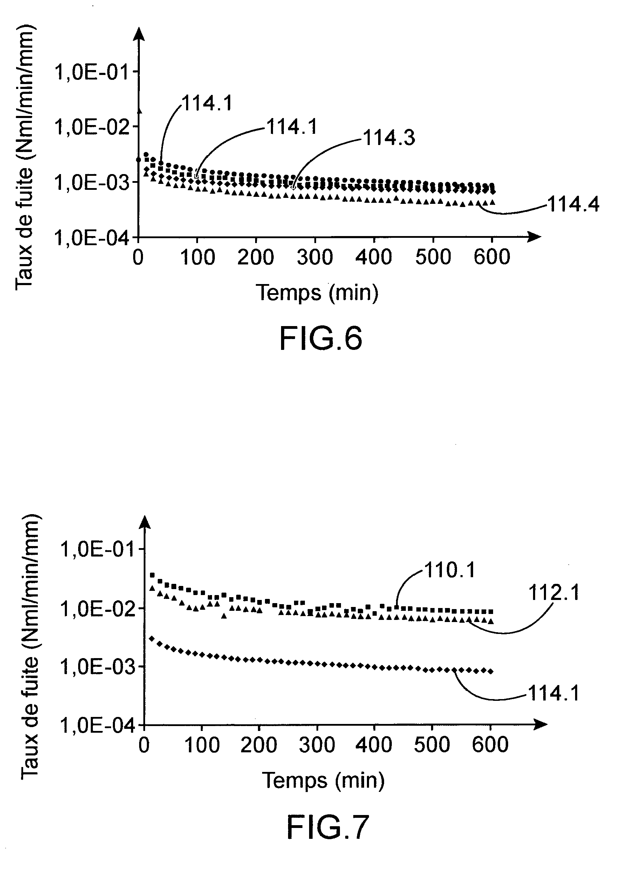

Les courbes 110.1 à 110.4 représentées sur la figure 4 correspondent aux taux de fuite mesurés au cours des différentes phases de la déformation du second joint 10 par les différents bossages 104.1 à 104.4, pour un effort égal à environ 3 N/mm. De même, les courbes 112.1 à 112.4 et 114.1 à 114.4 représentées sur les figures 5 et 6 correspondent aux taux de fuite mesurés au cours des différentes phases de la déformation du joint 10 par les différents bossages 104.1 à 104.4, pour un effort respectivement égal à environ 5 N/mm et 10 N/mm.

Il ressort de ces courbes que plus le bossage est aigu, plus le taux de fuite est faible. En effet, plus le bossage est fin, plus l'effort appliqué est localisé et plus le joint va alors se déformer. En se déformant, le joint vient combler les rugosités présentes à l'interface entre le joint et le bossage, rallongeant ainsi le chemin de fuite du gaz qui a alors plus de difficultés à s'échapper.

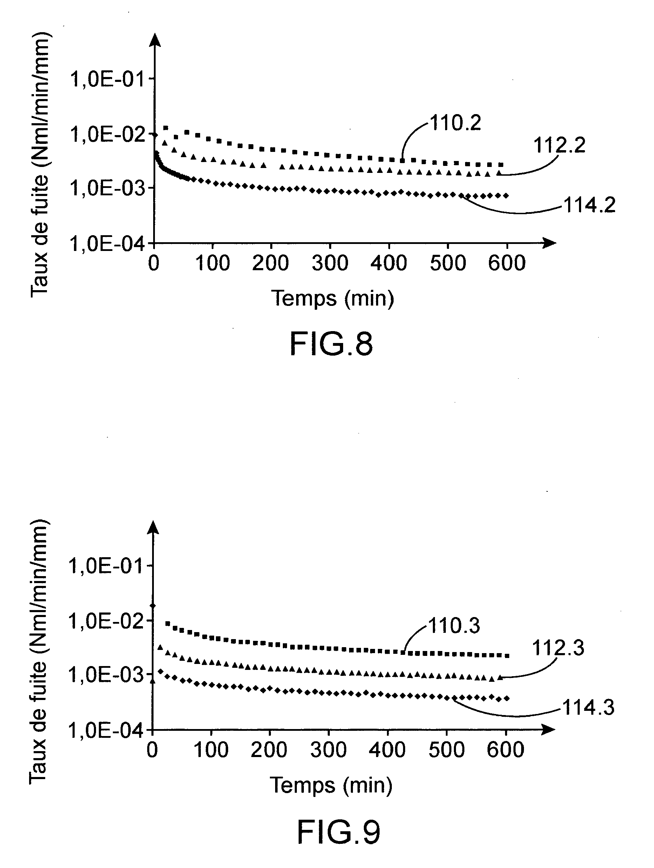

Ces mesures du taux de fuite sont également reportées sur les figures 7 à 10, les courbes étant cette fois regroupées en fonction du bossage utilisé.

Ainsi, sur la figure 7, les courbes 110.1, 112.1 et 114.1 précédemment représentées sur les figures 4 à 6 sont regroupées sur un même graphique afin de comparer l'influence de l'effort pour un même bossage.

A partir de ces figures 7 à 10, on voit que quelque soit le bossage utilisé, le taux de fuite diminue lorsque l'effort augmente. Ainsi, plus l'effort transmis au joint est important, plus il va fluer et moins le gaz aura de facilité à s'échapper.

Il est possible de contrôler que l'effort a bien été réparti sur tout le joint en mesurant par profilométrie laser en différentes zones le profil du second joint 10 ayant subi la déformation. Il est également possible de comparer cette déformation expérimentale avec celle calculée ultérieurement.

Cette phase de mesure expérimentale du taux de fuite n'est mise en oeuvre que si l'on souhaite déterminer les coefficients $\lambda$, $\alpha$ et $\beta$ propres au matériau du joint dont on cherche à estimer l'étanchéité. Si ces coefficients sont connus, il n'est pas nécessaire de réaliser ces mesures, l'étanchéité pouvant être estimée par calcul, sans mesure, comme cela est décrit ci-dessous.

On décrit maintenant la phase de simulation et de calcul permettant, lorsque les coefficients A, $\alpha$ et $\beta$ propres au matériau du joint sont inconnus, de déterminer ces coefficients en utilisant notamment la mesure du coefficient de bouchage de porosités expérimental $F_{exp}$ précédemment réalisée.

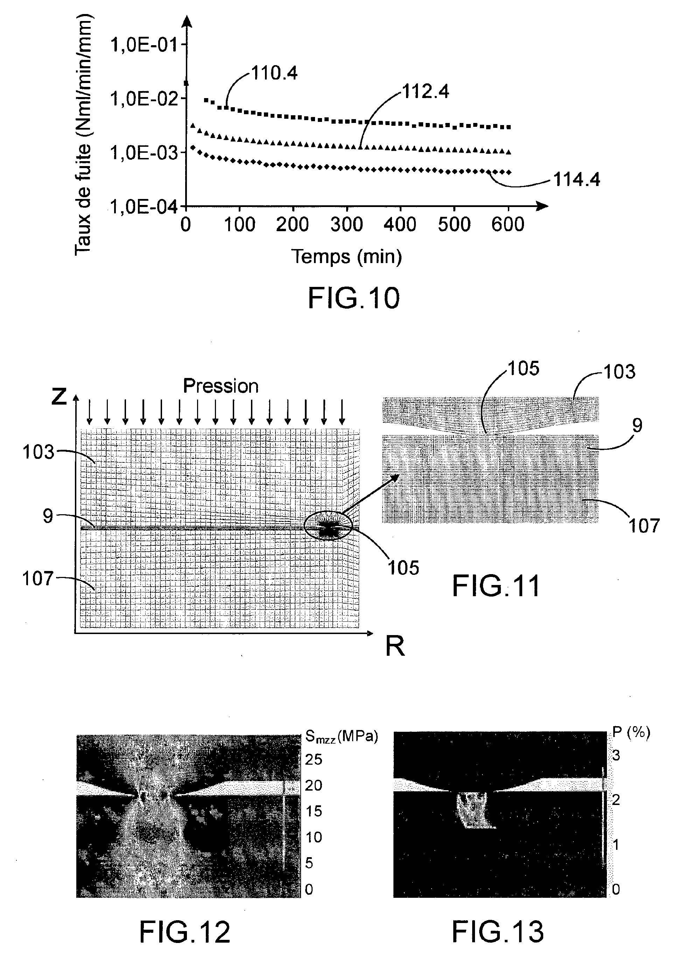

On réalise tout d'abord un maillage numérique représentant un joint 9 dont on cherche à évaluer l'étanchéité, et des éléments 103 et 107 entre lesquels le joint 9 est destiné à être disposé. Les éléments 103 et 107 correspondent par exemple à une cellule électrochimique et un interconnecteur métallique d'un l'électrolyseur EHT entre lesquels le joint 9 est destiné à assurer l'étanchéité. Par analogie avec la mesure précédemment réalisée, les éléments 103 et 107 seront appelés par la suite « portées ». Le maillage numérique du joint 9 et des portées 103, 107 est représenté sur la figure 11. Afin de faciliter la compréhension de l'invention, la géométrie (profil) du joint 9 est ici similaire à celle du second joint 10. Les géométries (profils) des portées 103 et 107 sont également analogues à celles des portées 102 et 104, excepté que dans l'exemple décrit ici, on suppose que c'est la portée supérieure 103 qui comporte un bossage 105 (de profil similaire au bossage 104) destiné à venir écraser le joint 9.

On simule numériquement une déformation par fluage du joint 9, et on détermine par la suite les champs mécaniques locaux du joint accessibles par cette simulation numérique de la déformation par fluage. En effet, par analogie avec les lois d'endommagement dans lesquelles les contraintes et la déformation par accumulation de dommages font apparaître des trous, ou porosités, dans le matériau conduisant à sa rupture, le taux de fuite que l'on cherche ici à estimer est lié à l'apparition ou au bouchage de trous dans le milieu poreux, à savoir aux interfaces entre le joint 9 et les portées 103 et 107. On cherche donc à exprimer ce taux de fuite en fonction des paramètres mécaniques pertinents qui contribuent au bouchage des porosités afin d'estimer théoriquement et a priori le débit de fuite d'un joint donné en fonction de certains paramètres à déterminer numériquement.

La simulation numérique de la déformation par fluage du joint d'étanchéité 9 est réalisée par ordinateur, ici par l'intermédiaire d'un logiciel de calcul mécanique par éléments finis, capable de calculer les champs mécaniques locaux lors d'une déformation par fluage, par exemple le logiciel Cast3M.

Les champs mécaniques pris en considération ici sont la contrainte axiale, notée *Smzz* et correspondant à la contrainte selon l'axe Z représenté sur la figure 2, et la déformation plastique cumulée notée *p*. Le calcul est effectué par exemple en 2D axisymétrique. Les différents éléments sont modélisés en utilisant par exemple des éléments de type quadrangle à interpolation quadratique et à intégration réduite (8 noeuds et 4 points de Gauss pour chaque quadrangle). Dans le cas présent, la modélisation du joint 9, des portées 103, 107 et du bossage 105 est réalisée avec 12800 éléments et 38000 noeuds dans le modèle. Les portées 103, 107 sont modélisées en leur conférant les propriétés de l'Udimet 720, c'est-à-dire un comportement élastique à 800°C. Le joint 9 en fecralloy a un comportement élasto-viscoplastique à 800°C selon une loi de type puissance telle que :

$$\dot{\varepsilon} = de_0 \left( \sinh\left(\frac{\sigma - \sigma_{seuil}}{\sigma_0}\right) \right)^b \qquad (12)$$

avec

$\dot{\varepsilon}$ : vitesse de déformation

$de_0$ : constante égale à 0,51 s$^{-1}$

σ : contrainte, en MPa

$\sigma_{seuil}$ : contrainte seuil valant 1 MPa

$\sigma_0$ : constante valant 221,75 MPa

$b$ : constante valant 4,58.

La modélisation du joint 9 est donc réalisée en lui conférant un tel comportement.

La modélisation du bossage 105 peut être réalisée à partir du profil réel du bossage mesuré par profilométrie laser, qui est lissé ensuite par un polynôme dont les coefficients sont rentrés en tant que paramètres dans le fichier de mise en données du logiciel Cast3M. Il est donc possible de modifier le profil du bossage modélisé en modifiant seulement ces coefficients, le maillage étant ensuite généré automatiquement par le logiciel. Dans l'exemple décrit ici, le bossage 105 modélisé comporte un profil correspondant au profil 104.3 représenté sur la figure 3.

Dans la simulation, le contact est géré de part et d'autre du joint, c'est-à-dire à la fois du côté de la portée inférieure et du côté de la portée supérieure, et un coefficient de frottement égal à 0,2 est appliqué.

La modélisation des différents éléments 9, 103, 105 et 107 réalisée ici est représentée sur la figure 11. Le modèle est bloqué dans la direction R (direction parallèle au plan principal du joint 9) et la portée inférieure 102 est bloquée dans la direction Z, c'est-à-dire considérée comme fixe dans la direction perpendiculaire au plan principal du joint 9. La pression est appliquée uniformément sur le haut de la portée supérieure 103. La simulation est réalisée en considérant que le joint 9 est pressé entre les portées 103 et 107 pendant une longue durée, par exemple plusieurs années.

Lors de la simulation, les champs mécaniques sont étudiés après la mise en charge, après 20 min, 40 min puis toutes les heures jusqu'à la fin du chargement.

Les figures 12 et 13 représentent la répartition de la contrainte axiale *(Smzz)* et de la déformation plastique cumulée (p) dans les éléments modélisés, calculées après un maintien de la pression pendant 10 heures.

La fuite se produisant entre le joint 9 et la portée 103 comportant le bossage 105, les champs mécaniques (contrainte axiale et déformation plastique cumulée) intervenant au contact entre ces deux parties sont les plus pertinents car les plus susceptibles d'avoir une influence sur le niveau d'étanchéité mesuré. A un instant t, ces grandeurs sont calculées aux points de Gauss des éléments modélisés. Pour chaque incrément de temps, la valeur de ces paramètres dans l'élément est moyennée. Ces valeurs sont ensuite ramenées aux noeuds pour le post traitement.

En variante, lorsque la fuite se produit entre le joint 9 et les deux portées 103 et 107, on considère les champs mécaniques locaux au niveau des deux interfaces entre le joint et ces portées. Si la géométrie de ces éléments est symétrique (par exemple lorsque les portées ne présentent pas de bossage et que le profil du joint est le même au niveau de ces deux interfaces), il sera possible de considérer que la fuite sera similaire au niveau de ces deux interfaces et de ne calculer les champs mécaniques qu'au niveau d'une seule interface.

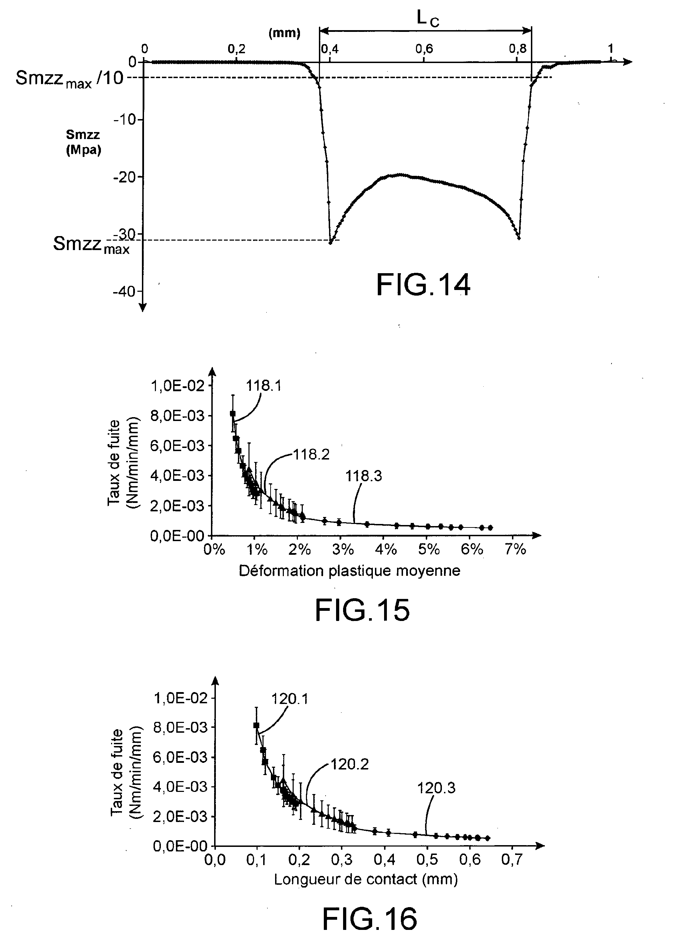

Un des paramètres importants ayant une influence sur le débit de fuite est la longueur de contact entre le bossage 105 et le joint 9. Celle-ci est déterminée en se basant sur la contrainte axiale calculée entre le joint 9 et le bossage 105 : lorsque la contrainte est nulle, cela signifie que le bossage 105 et le joint 9 ne se touchent pas, et inversement si la contrainte axiale est non nulle. La figure 14 représente graphiquement cette contrainte axiale au cours de la déformation par fluage simulée du joint 9, à l'interface entre le joint 9 et le bossage 105. On voit sur cette figure 14 que la contrainte axiale présente un profil comportant deux pics, ou maxima, distincts 116.1 et 116.2. Une méthode analytique pour déterminer la longueur de contact consiste à sélectionner la valeur maximale de la contrainte axiale $Smzz_{max}$ . Cette contrainte axiale maximale $Smzz_{max}$ est alors divisée par 10. La valeur obtenue est ensuite extrapolée polynômialement afin de trouver les deux abscisses correspondantes. La longueur de contact *Lc* correspond alors à la différence entre les deux abscisses obtenues. En variante, il est également possible de considérer que la longueur de contact correspond à la distance sur laquelle la contrainte axiale est non nulle.

Les champs mécaniques pris en considération ici pour déterminer par calcul le taux de fuite du joint 9 sont la contrainte axiale *Smzz* et la déformation plastique cumulée *p*.

En effet, les courbes 118.1 à 118.3 et 120.1 à 120.3 des figures 15 et 16 représentent le taux de fuite expérimental mesuré en fonction respectivement de la déformation plastique cumulée moyenne le long du contact joint - bossage et de la longueur de contact *Lc* calculés sous Cast3M pour ces mêmes essais. Les courbes 118.1 à 118.3 et 120.1 à 120.3 concernent le bossage 104.3 pour des efforts de 3, 5 et 10 N/mm. Pour chaque niveau d'effort, trois essais ont été menés et la dispersion expérimentale a été reportée à l'aide de barres d'erreurs. Enfin, à chaque niveau d'effort, les mesures et les calculs ont été faits à respectivement 20min, 40min, 1h puis toutes les heures jusqu'à 10h.

Les différents points de ces courbes correspondent donc aux valeurs à ces différents pas de temps.

Lorsqu'est considérée une unique géométrie de bossage, on voit donc, à partir de ces courbes, que le taux de fuite est relié directement à la déformation plastique cumulée et à la longueur de contact. On voit que le taux de fuite diminue lorsque les grandeurs pertinentes retenues que sont la déformation plastique cumulée et la longueur de contact augmentent, et une certaine continuité est constatée lors du passage d'un niveau de chargement à l'autre. Une seule de ces grandeurs (déformation plastique cumulée ou longueur de contact) peut permettre d'estimer a priori le taux de fuite, pour un bossage à géométrie fixe.

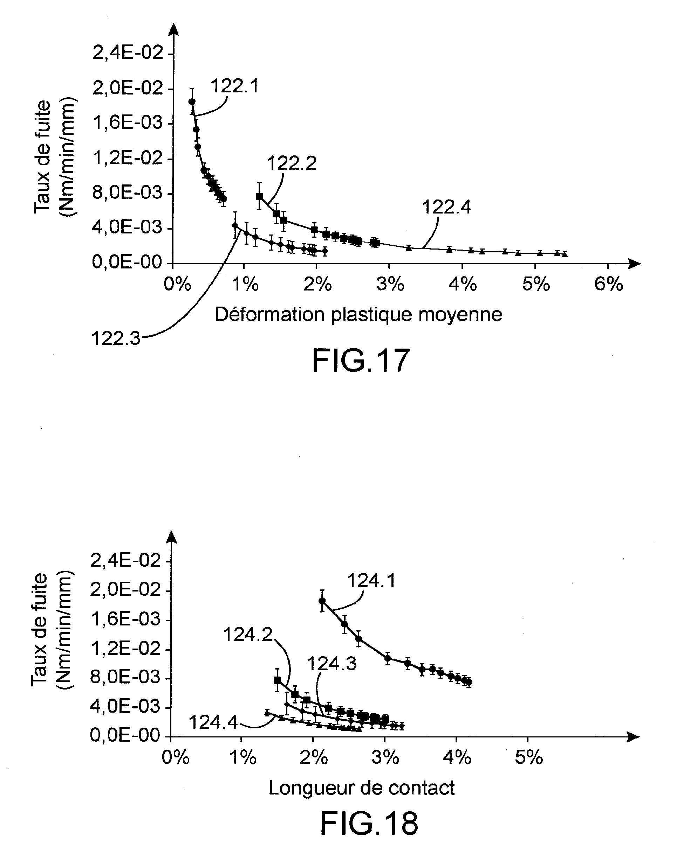

Les courbes 122.1 à 122.4 et 124.1 à 124.4 des figures 17 et 18 représentent également le taux de fuite expérimental mesuré en fonction respectivement de la déformation plastique cumulée moyenne le long du contact joint - bossage et de la longueur de contact $Lc$ calculés sous Cast3M pour ces mêmes essais, mais en considérant les différents bossages 104.1 à 104.4 et un niveau d'effort de valeur fixe (ici 5 N/mm). Les barres d'erreurs correspondent à la dispersion expérimentale, et chaque point de ces courbes correspond à une mesure faite à un certain pas de temps.

A la différence du cas précédent (géométrie fixée et effort variable), lorsque le niveau de chargement (l'effort) est fixé mais que le type de géométrie du bossage change, la relation liant le taux de fuite avec les paramètres étudiés (déformation plastique cumulée et longueur de contact) n'est pas directe étant donné qu'il n'y a pas de fonction assurant une continuité des grandeurs au passage d'une géométrie à l'autre.

D'autres éléments sont considérés pour enrichir cette approche. La déformation plastique cumulée et la longueur de contact sont donc corrélées à différentes puissances afin de les relier au taux de fuite mesuré. Ainsi, par analogie avec les lois de type endommagement où les contraintes et la déformation par accumulation de dommage font apparaître des trous dans le matériau conduisant à sa rupture, le taux de fuite est lié à l'apparition ou au bouchage de trous dans le milieu poreux. Le dommage correspondant ici à un bouchage de trous sera exprimé en fonction des paramètres identifiés que sont la déformation plastique cumulée $p$ et la contrainte axiale $Smzz$. En se plaçant à un instant t, le taux de fuite expérimental ainsi que l'histoire du trajet de chargement numérique sont connus.

La contrainte axiale $Smzz$ et la déformation plastique cumulée $p$ sont calculées aux points de Gauss des éléments. Pour chaque incrément de temps, la valeur de ces paramètres dans l'élément est moyennée, puis ces valeurs sont ramenées aux noeuds pour le post traitement. On dispose alors d'une valeur correspondant aux conditions nécessaires à un bouchage de trou au niveau local, c'est-à-dire pour chaque noeud le long du contact entre la portée et le joint. Ce bouchage de porosité calculé pour chaque noeud s'écrit :

$$D_{noeud} = \int_{p} \lambda * \left( \frac{Smzz}{\sigma_{seuil}} \right)^{\alpha} * \left( \frac{p}{p_0} \right)^{\beta} dp \qquad (13)$$

L'intervalle d'intégration de $p$ est compris entre 0 et la valeur maximale atteinte par $p$ au cours de la simulation, appelée pmax.

D'après l'équation (11) issue de la loi de Darcy, le bouchage de porosités est lié à la perméabilité du milieu ainsi qu'à une hauteur de passage. Ces caractéristiques peuvent être reliées au bouchage de porosité calculé $D_{noeud}$. Ainsi, lorsque $D_{noeud}$ augmente, cela signifie que la porosité est comblée et que le fluide aura moins de facilité à s'échapper par la porosité. Ce terme correspond alors à $\dfrac{1}{\kappa(r)}$, terme qui doit ensuite être intégré le long du contact (la variable r correspondant à la position le long de ce contact) à l'instant t considéré pour tenir compte de toutes les rugosités bouchées ou créées intervenant dans le trajet de fuite.

On a donc :

$$F_{num} = \int_{r_i}^{r_e} \frac{dr}{k(r)r} = \int_{r_i}^{r_e} \frac{D_{noeud} * dr}{r} \qquad (14)$$

Lorsque les coefficients $\lambda$, $\alpha$ et $\beta$ propres au matériau du joint 9 sont inconnus, on les détermine alors en minimisant l'écart entre $F_{exp}$ et $F_{num}$. Cette minimisation est réalisée par exemple en appliquant la méthode des moindres carrés : on part de valeurs approximatives des coefficients $\lambda$, $\alpha$ et $\beta$ afin de rapprocher les valeurs de $F_{exp}$ et $F_{num}$. Par une méthode itérative d'optimisation, on cherche alors à réduire l'écart de valeurs entre $F_{exp}$ et $F_{num}$ jusqu'à aboutir à la minimisation souhaitée. On peut par exemple accepter une tolérance égale à environ 1% pour cet écart de valeurs entre $F_{exp}$ et $F_{num}$.

Par exemple, pour un joint en fecralloy, on a par exemple : $\lambda$ = 1,86E15, $\alpha$ = 5,58E-2 et $\beta$ = -5,99E-2.

Les coefficients $\lambda$, $\alpha$ et $\beta$ rendent compte de l'influence des deux paramètres considérés (déformation plastique cumulée le long du contact et contrainte axiale) et le rôle prépondérant constaté expérimentalement de la déformation plastique cumulée sur le taux de fuite. Ainsi, si au cours d'un essai, l'effort appliqué est diminué et qu'en conséquence la contrainte axiale diminue, le taux de fuite lui n'augmente pas.

A partir du coefficient de bouchage de porosités simulé $F_{num}$, on peut donc évaluer l'étanchéité du joint 9, et refaire des simulations en modifiant certains paramètres géométriques du joint pour optimiser cette étanchéité.

En connaissant les valeurs des coefficients $\lambda$, $\alpha$ et $\beta$ pour un matériau donné, on peut donc estimer l'étanchéité de n'importe quel type de joint comportant ce matériau en réalisant la simulation précédemment décrite.

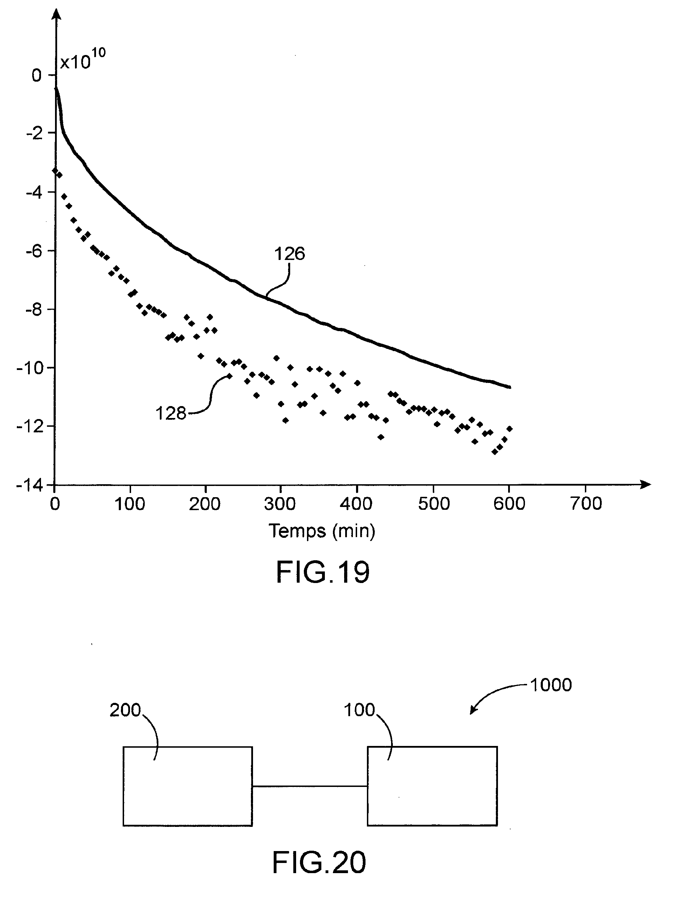

La courbe 126 représentée sur la figure 19 correspond aux valeurs de $F_{num}$ obtenues au cours du procédé d'estimation de l'étanchéité d'un joint de fecralloy précédemment décrit et réalisé avec le bossage 104.1 avec un effort égal à 3 N/mm. Par comparaison, les points 128 représentés sur la figure 19 correspondent aux valeurs de $F_{exp}$ calculées pour une même déformation du joint.

La figure 20 représente un dispositif 1000 d'estimation de l'étanchéité d'un joint. Le dispositif 1000 comporte le dispositif de mesure 100 précédemment décrit, ainsi que des moyens informatiques 200 aptes à mettre en oeuvre notamment la simulation numérique de la déformation par fluage du joint et les différents calculs réalisés lors du procédé d'estimation de l'étanchéité du joint 9. Les moyens informatiques 200 comportent par exemple un ou plusieurs ordinateurs sur lesquels des moyens logiciels tels que le logiciel de calcul mécanique par éléments finis, capable notamment de calculer les champs mécaniques locaux lors de la simulation de la déformation par fluage du joint, par exemple le logiciel Cast3M, sont installés. Les moyens informatiques 200 peuvent également comporter des moyens de calcul pour calculer par exemple le coefficient de bouchage de porosités expérimental $F_{exp}$ à partir des mesures réalisées par le dispositif de mesure 100 ou calculer les coefficients $\lambda$, $\alpha$ et $\beta$ en minimisant l'écart entre les valeurs des coefficients $F_{num}$ et $F_{exp}$. Pour cela, les moyens informatiques peuvent être couplés au dispositif de mesure 100, comme représenté sur la figure 20, afin que des échanges de données puissent être réalisés entre les moyens informatiques 200 et les moyens de mesure et/ou de commande du dispositif de mesure 100. Le dispositif de mesure 100 peut notamment être piloté, lors des mesures d'une fuite du joint 9, par les moyens 200.

**Revendications**

1. Procédé d'estimation de l'étanchéité d'un joint (9), comportant au moins les étapes suivantes :

   - simulation numérique d'une déformation par fluage du joint (9) par écrasement du joint (9) entre deux portées (103, 107) ;
   - calcul, à au moins une interface entre le joint (9) et l'une des deux portées (103), d'une déformation plastique cumulée $p$ du joint (9), d'une contrainte axiale $Smzz$ entre le joint (9) et ladite une des deux portées (103), et d'une longueur de contact $Lc$ entre le joint (9) et ladite une des deux portées (103), au cours de la simulation numérique ;
   - calcul d'un coefficient de bouchage de porosités simulé $F_{num}$, représentatif de l'étanchéité du joint (9) à ladite interface entre le joint (9) et ladite une des deux portées (103), tel que :

$$F_{num} = \int_{ri}^{re} \int_{0}^{p\,max} \lambda . \left( \frac{Smzz}{\sigma_{seuil}} \right)^{\alpha} . \left( \frac{p}{p_0} \right)^{\beta} dp \frac{dr}{r} \, ,$$

avec

$\lambda$, $\alpha$ et $\beta$ : coefficients dont les valeurs dépendent du matériau du joint (9),
re et $ri$ : respectivement le rayon extérieur et le rayon intérieur de la déformation du joint, en m,
$r$ : position le long du contact entre le joint et ladite au moins une des deux portées,
$Lc = re - ri$, en m,
$Smzz$ : contrainte axiale, en MPa,
$\sigma_{seuil}$ : contrainte seuil égale à 1 MPa,
$p$ : déformation plastique cumulée,
$pmax$ : valeur maximale atteinte par p au cours de la simulation,
$p_0$ : constante égale à 1,
et dans lequel la simulation numérique et les calculs sont mis en oeuvre par ordinateur.

**2.** Procédé selon la revendication 1, comportant en outre, après l'étape de calcul du coefficient de bouchage de porosités simulé $F_{num}$, une étape de calcul d'un débit massique de fuite simulé $Q_{mnum}$ d'un fluide au sein d'un espace étanchéifié par le joint (9), tel que :

$$Q_{mnum} = \frac{\pi.M}{\mu.R.T.F_{num}}\left(Pe^2 - Pi^2\right),$$

avec

$M$ : masse molaire du fluide, en kg/mol
$\mu$ : viscosité dynamique du fluide, en Pa.s
$R$ = 8,314 J/K/mol
$T$ : température du fluide, en K
$Pi$ : pression dans l'espace étanchéifié, en Pa
$Pe$ : pression hors de l'espace étanchéifié, en Pa.

**3.** Procédé selon l'une des revendications précédentes, comportant en outre, lorsque les valeurs des coefficients A, $\alpha$ et $\beta$ sont inconnues pour le matériau du joint (9), une détermination des valeurs des coefficients A, $\alpha$ et $\beta$ correspondant au matériau du joint (9) obtenue en réalisant les étapes suivantes :

- mesure d'un débit massique $Q_m$ d'un fluide permettant de maintenir ce fluide à une pression $Pi$ sensiblement constante dans un espace étanchéifié par un second joint (10) comportant ledit matériau au cours d'une déformation par fluage du second joint (10) par écrasement du second joint (10) entre deux portées (102, 106),
- calcul d'un coefficient de bouchage de porosités expérimental $F_{exp}$, représentatif de l'étanchéité du second joint (10) à au moins une interface entre le second joint (10) et une des deux portées (102), tel que :

$$F_{exp} = \frac{\pi.M}{\mu.R.T.Q_m}\left(Pe^2 - Pi^2\right),$$

avec

$M$ : masse molaire du fluide, en kg/mol
$\mu$ : viscosité dynamique du fluide, en Pa.s
$R$ = 8,314 J/K/mol
$T$ : température du fluide, en K
$Q_m$ : débit massique du fluide, en kg/s
$Pi$ : pression dans l'espace étanchéifié, en Pa
$Pe$ : pression hors de l'espace étanchéifié, en Pa,

et, après le calcul du coefficient de bouchage de porosités simulé $F_{num}$, une étape de calcul des valeurs des coefficients $\lambda$, $\alpha$ et $\beta$ réalisée par minimisation de l'écart entre les valeurs des coefficients $F_{num}$ et $F_{exp}$.

**4.** Procédé selon la revendication 3, dans lequel l'étape de calcul des valeurs des coefficients $\lambda$, $\alpha$ et $\beta$ est réalisée en appliquant la méthode des moindres carrés.

**5.** Procédé selon l'une des revendications 3 ou 4, dans lequel l'étape de mesure du débit massique $Q_m$ est obtenue en réalisant :

- une première étape de montée en température du second joint (10) et des portées (102, 106) ;
- une deuxième étape de mise en contact et de mise en pression des portées (102, 106) contre le second joint (10) ;
- une troisième étape de maintien de la pression exercée par les portées (102, 106) contre le second joint (10) ;

- une quatrième étape de réduction de la pression exercée par les portées (102, 106) contre le second joint (10) ;
- une cinquième étape de séparation d'au moins une des portées (102, 106) et du second joint (10).

**6.** Procédé selon la revendication 5, dans lequel la première étape de montée en température est mise en oeuvre jusqu'à atteindre une température comprise entre environ 600°C et 1000°C, et/ou dans lequel la pression exercée par les portées (102, 106) sur le second joint (10) lors de la troisième étape correspond à un effort exercé par au moins l'une des portées (102, 106) sur le second joint (10) compris entre environ 3 N/mm et 10 N/mm, et/ou dans lequel la troisième étape de maintien de la pression exercée par les portées (102, 106) sur le second joint (10) est mise en oeuvre pendant une durée comprise entre environ 5 heures et 15 heures.

**7.** Procédé selon l'une des revendications précédentes, dans lequel l'étape de simulation numérique est mise en oeuvre par l'intermédiaire d'un logiciel de calcul mécanique par éléments finis.

**8.** Procédé selon l'une des revendications précédentes, comportant en outre, préalablement à l'étape de simulation numérique, une étape de mesure par profilométrie laser du profil du joint (9) et/ou des portées (103, 107), un maillage numérique du joint (9) et/ou des portées (103, 107), utilisé au cours de l'étape de simulation numérique, étant réalisé à partir du profil mesuré du joint (9) et/ou des portées (103, 107).

**9.** Procédé selon l'une des revendications précédentes, dans lequel la longueur de contact *Lc* est obtenue en calculant, par extrapolation polynômiale de la contrainte axiale *Smzz* exprimée en fonction d'une position au niveau de ladite interface entre le joint (9) et ladite une des deux portées (103), les valeurs de deux abscisses correspondant à la valeur maximale divisée par 10 de la contrainte axiale *Smzz,* la longueur de contact *Lc* correspondant à la différence entre lesdites valeurs des deux abscisses.

**10.** Dispositif (1000) d'estimation de l'étanchéité d'un joint (9), comportant des moyens (100, 200) aptes à mettre en oeuvre un procédé d'estimation de l'étanchéité d'un joint (9) selon l'une des revendications précédentes.

**11.** Produit programme d'ordinateur mémorisant un code exécutable pour la mise en oeuvre d'un procédé d'estimation de l'étanchéité d'un joint (9) selon l'une des revendications 1 à 9.

**Patentansprüche**

**1.** Verfahren zum Bewerten der Dichtheit einer Dichtung (9), das zumindest die nachfolgenden Schritte umfasst:

- numerische Simulation einer Kriechverformung der Dichtung (9) durch Zusammendrücken der Dichtung (9) zwischen zwei Lagerflächen (103, 107);
- Berechnen einer kumulierten plastischen Verformung *p* der Dichtung (9), einer axialen Spannung *Smzz* zwischen der Dichtung (9) und einer der beiden Lagerflächen (103), und einer Kontaktlänge *Lc* zwischen der Dichtung (9) und der einen der beiden Lagerflächen (103) an zumindest einer Schnittstelle zwischen der Dichtung (8) und der einen der beiden Lagerflächen (103) im Laufe der numerischen Simulation;
- Berechnen eines simulierten Porositätsverschließkoeffizienten $F_{num}$, der für die Dichtheit der Dichtung (9) an der Schnittstelle zwischen der Dichtung (9) und einer der beiden Lagerflächen (103) repräsentativ ist, so dass:

$$F_{num}= \int_{ri}^{re} \int_{0}^{p\max} \lambda \cdot \left( \frac{Smzz}{\sigma_{Schwellwert}} \right)^{a} \cdot \left( \frac{p}{p_0} \right)^{\beta} dp \frac{dr}{r}$$

mit
$\lambda$, $\alpha$ und $\beta$: Koeffizienten, deren Werte vom Material der Dichtung (9) abhängen,
*re* und *ri* : der Außenradius bzw. der Innenradius der Verformung der Dichtung in m,
r: Position entlang des Kontakts zwischen der Dichtung und der zumindest einen der beiden Lagerflächen,
*Lc=re-ri,* in m,
*Smzz:* axiale Spannung in MPa,
$\sigma_{Schwellwert}$: Spannungsschwellwert gleich 1 MPa,
*p*: kumulierte, plastische Verformung,

*pmax:* Höchstwert, der für p im Laufe der Simulation erreicht wird,

$p_0$: Konstante gleich 1,

und wobei die numerische Simulation und die Berechnungen per Computer erfolgen.

**2.** Verfahren nach Anspruch 1, ferner umfassend nach dem Schritt des Berechnens des simulierten Porositätsverschließkoeffizienten $F_{num}$ einen Schritt des Berechnens eines simulierten Leckmassendurchsatzes $Q_{mnum}$ einer Mediums innerhalb eines durch die Dichtung (9) abgedichteten Raums, so dass:

$$Q_{mnum} = \frac{\pi \cdot M}{\mu \cdot R \cdot T \cdot F_{num}}\left(Pe^2 - Pi^2\right)$$

mit

$M$: Molare Masse des Mediums in kg/mol

$\mu$: dynamische Viskosität des Mediums in Pa.s

$R$= 8,314 J/K/mol

$T$: Temperatur des Mediums in K

Pi: Druck im abgedichteten Raum, in Pa

Pe: Druck außerhalb des abgedichteten Raums in Pa.

**3.** Verfahren nach einem der vorangehenden Ansprüche, ferner umfassend dann, wenn die Werte der Koeffizienten $\lambda$, $\alpha$ und $\beta$ für das Material der Dichtung (9) unbekannt sind, eine Ermittlung der Werte der Koeffizienten $\lambda$, $\alpha$ und $\beta$ entsprechend dem Material der Dichtung (9), die mit dem Durchführen der nachfolgenden Schritte erhalten wird:

- Messen eines Massendurchsatzes $Q_m$ eines Mediums, mit dem dieses Fluid auf einem im Wesentlichen konstanten Druck $Pi$ in einem Raum gehalten werden kann, der über eine zweite Dichtung (10) mit dem genannten Material abgedichtet wird, und zwar im Laufe einer Kriechverformung der zweiten Dichtung (10) durch Zusammendrücken der zweiten Dichtung (10) zwischen zwei Lagerflächen (102, 106),

- Berechnen eines empirischen Porositätsverschließkoeffizienten $F_{exp}$, der für die Dichtheit der zweiten Dichtung (10) an zumindest einer Schnittstelle zwischen der zweiten Dichtung (10) und einer der beiden Lagerflächen (102) repräsentativ ist, so dass:

$$F_{exp} = \frac{\pi \cdot M}{\mu \cdot R \cdot T \cdot Q_m}\left(Pe^2 - Pi^2\right)$$

mit

$M$: Molare Masse des Mediums in kg/mol

$\mu$: dynamische Viskosität des Mediums in Pa.s

$R$= 8,314 J/K/mol

$T$: Temperatur des Mediums in K

$Q_m$: Massendurchsatz des Mediums in kg/s

Pi: Druck im abgedichteten Raum, in Pa

Pe: Druck außerhalb des abgedichteten Raums in Pa,

und nach dem Berechnen des simulierten Porositätsverschließkoeffizienten $F_{num}$ einen Schritt des Berechnens der Werte der Koeffizienten $\lambda$, $\alpha$ und $\beta$, der durch Minimisierung einer Abweichung zwischen den Werten der Koeffizienten $F_{num}$ und $F_{exp}$ erfolgt.

**4.** Verfahren nach Anspruch 3, wobei der Schritt des Berechnens der Werte der Koeffizienten $\lambda$, $\alpha$ und $\beta$ durch Anwendung der Methode der kleinsten Quadrate erfolgt.

**5.** Verfahren nach einem der Ansprüche 3 oder 4, wobei der Schritt des Messens des Massendurchsatzes $Q_m$ erhalten wird durch Ausführen von

- einem ersten Schritt des Anhebens der Temperatur der zweiten Dichtung (10) und der Lagerflächen (102, 106);

- einem zweiten Schritt des Inkontaktbringens und Andrückens der Lagerflächen (102, 106) an die zweite Dichtung (10);
- einem dritten Schritt des Haltens von dem Druck, der von den Lagerflächen (102, 106) auf die zweite Dichtung (10) ausgeübt wird;
- einem vierten Schritt des Verminderns von dem Druck, der von den Lagerflächen (102, 106) auf die zweite Dichtung (10) ausgeübt wird;
- einem fünften Schritt des Trennens zumindest einer der Lagerflächen (102, 106) und der zweiten Dichtung (10).

6. Verfahren nach Anspruch 5, wobei der erste Schritt des Anhebens der Temperatur solange erfolgt, bis eine Temperatur von zwischen etwa 600 °C und 1000 °C erreicht wird, und/oder wobei der von den Lagerflächen (102, 106) auf die zweite Dichtung (10) ausgeübte Druck im dritten Schritt einer Kraft entspricht, die von zumindest einer der Lagerflächen (102, 106) auf die zweite Dichtung (10) ausgeübt wird und die zwischen etwa 3 N/mm und 10 N/mm liegt, und wobei der dritte Schritt des Haltens von dem Druck, der von den Lagerflächen (102, 106) auf die zweite Dichtung (10) ausgeübt wird, für eine Zeitdauer zwischen etwa 5 Stunden und 15 Stunden ausgeführt wird.

7. Verfahren nach einem der vorangehenden Ansprüche, wobei der Schritt der numerischen Simulation durch eine Finite-Elemente-Rechensoftware erfolgt.

8. Verfahren nach einem der vorangehenden Ansprüche, ferner umfassend vor dem Schritt der numerischen Simulation einen Schritt des Messens des Profils der Dichtung (9) und/oder der Lagerflächen (103, 107) durch Laser-Profilometrie, wobei ein numerisches Gitter der Dichtung (9) und/oder der Lagerflächen (103, 107), das beim Schritt der numerischen Simulation angewendet wird, ausgehend von dem gemessenen Profil der Dichtung (9) und/oder der Lagerflächen (103, 107) erzeugt wird.

9. Verfahren nach einem der vorangehenden Ansprüche, wobei die Kontaktlänge Lc dadurch erhalten wird, dass durch polynomiale Extrapolation der axialen Spannung *Smzz*, ausgedrückt als Funktion einer Position im Bereich der Schnittstelle zwischen Dichtung (9) und einer der beiden Lagerflächen (103), die Werte der beiden Abszissen berechnet werden, die dem Höchstwert der axialen Spannung *Smzz* dividiert durch 10 entsprechen, wobei die Kontaktklänge *Lc* der Differenz zwischen den Werten der beiden Abszissen entspricht.

10. Vorrichtung (1000) zum Bewerten der Dichtheit einer Dichtung (9), enthaltend Mittel (100, 200), die dazu geeignet sind, ein Verfahren zum Bewerten der Dichtheit einer Dichtung (9) nach einem der vorangehenden Ansprüche durchzuführen.

11. Computerprogrammprodukt, bei dem ein Code abgespeichert ist, der zum Durchführen eines Verfahrens zum Bewerten der Dichtheit einer Dichtung (9) nach einem der Ansprüche 1 bis 9 ausführbar ist.

**Claims**

1. Method for estimating the tightness of a seal (9), including at least the following steps:

- digital simulation of a deformation by creep of the seal (9) by compression of the seal (9) between two surfaces (103, 107);
- calculation, at at least one interface between the seal (9) and one of the two surfaces (103), of a cumulative plastic deformation *p* of the seal (9), of an axial stress *Smzz* between the seal (9) and said one of the two surfaces (103), and of a contact length *Lc* between the seal (9) and said one of the two surfaces (103), during the digital simulation;
- calculation of a simulated pore plugging coefficient $F_{num}$, representative of the tightness of the seal (9) at said interface between the seal (9) and said one of the two surfaces (103), such that:

$$F_{num} = \int_{ri}^{re} \int_{0}^{p\,max} \lambda . \left( \frac{Smzz}{\sigma_{seuil}} \right)^{\alpha} . \left( \frac{p}{p_0} \right)^{\beta} dp \frac{dr}{r} \; ,$$

where

$\lambda$, $\alpha$ and $\beta$: coefficients the values of which depend on the material of the seal (9),
re and *ri:* respectively the external radius and the internal radius of the deformation of the seal, m,
r: position along the contact between the seal and said at least one of the two surfaces,
*Lc = re - ri,* m,
*Smzz:* axial stress, MPa,
$\sigma_{seuil}$: threshold stress equal to 1 MPa,
p: cumulative plastic deformation,
*pmax:* maximum value attained by p during the simulation,
$p_0$: constant equal to 1,

and in which the digital simulation and the calculations are implemented by computer.

2. A method according to claim 1, also including, after the step of calculation of simulated pore plugging coefficient $F_{num}$, a step of calculation of a simulated mass leakage flow rate $Q_{mnum}$ of a fluid within a space sealed by the seal (9), such that:

$$Q_{mnum} = \frac{\pi.M}{\mu.R.T.F_{num}}\left(Pe^2 - Pi^2\right),$$

where

M: molar mass of the fluid, kg/mol
$\mu$: dynamic viscosity of the fluid, Pa.s
$R$ = 8.314 J/K/mol
T: temperature of the fluid, K
*Pi:* pressure in the space which has been sealed, Pa
Pe: pressure outside the space which has been sealed, Pa.

3. A method according to one of the previous claims, also including, when the values of coefficients A, $\alpha$ and $\beta$ are unknown for the material of the seal (9), a determination of the values of coefficients A, $\alpha$ and $\beta$ corresponding to the material of the seal (9) obtained by performing the following steps:

- measurement of a mass flow rate $Q_m$ of a fluid enabling this fluid to be kept at a roughly constant pressure *Pi* in a space sealed by a second seal (10) comprising said material during a deformation by creep of the second seal (10) by compression of the second seal (10) between two surfaces (102, 106),
- calculation of an experimental pore plugging coefficient $F_{exp}$, representative of the tightness of the second seal (10) at at least one interface between the second seal (10) and one of the two surfaces (102), such that:

$$F_{exp} = \frac{\pi.M}{\mu.R.T.Q_m}\left(Pe^2 - Pi^2\right),$$

where

*M:* molar mass of the fluid, kg/mol
$\mu$: dynamic viscosity of the fluid, Pa.s
$R$ = 8.314 J/K/mol
*T:* temperature of the fluid, K
$Q_m$: mass flow rate of the fluid, kg/s
*Pi:* pressure in the space which has been sealed, Pa
Pe: pressure outside the space which has been sealed, Pa,

and, after the calculation of simulated pore plugging coefficient $F_{num}$, a step of calculation of the values of coefficients $\lambda$, $\alpha$ and $\beta$ made by minimising the difference between the values of coefficients $F_{num}$ and $F_{exp}$.

4. A method according to claim 3, in which the step of calculation of the values of coefficients $\lambda$, $\alpha$ and $\beta$ is made by applying the method of least squares.

5. A method according to either of claims 3 or 4, in which the step of measurement of mass flow rate $Q_m$ is obtained by accomplishing:

- a first step of raising the temperature of the second seal (10) and of the surfaces (102, 106);
- a second step of bringing the surfaces (102, 106) into contact against the second seal (10) and subjecting them to pressure;
- a third step of maintaining the pressure exerted by the surfaces (102, 106) against the second seal (10);
- a fourth step of reducing the pressure exerted by the surfaces (102, 106) against the second seal (10);
- a fifth step of separating at least one of the surfaces (102, 106) and the second seal (10).

6. A method according to claim 5, in which the first step of raising the temperature is implemented until a temperature of between approximately 600°C and 1000°C is reached, and/or in which the pressure exerted by the surfaces (102, 106) on the second seal (10) during the third step is equal to a force exerted by at least one of the surfaces (102, 106) on the second seal (10) between approximately 3 N/mm and 10 N/mm, and/or in which the third step of maintaining the pressure exerted by the surfaces (102, 106) on the second seal (10) is implemented during a period of between approximately 5 hours and 15 hours.

7. A method according to one of the previous claims, in which the step of digital simulation is implemented through a finite element mechanical calculation application.

8. A method according to one of the previous claims, also including, prior to the step of digital simulation, a step of measurement by laser profilometry of the profile of the seal (9) and/or of the surfaces (103, 107), where a digital mesh of the seal (9) and/or of the surfaces (103, 107), used in the course of the step of digital simulation, is produced from the measured profile of the seal (9) and/or of the surfaces (103, 107).

9. A method according to one of the previous claims, in which contact length Lc is obtained by calculating, by polynomial extrapolation of axial stress $Smzz$ expressed in terms of a position at said interface between the seal (9) and said one of the two surfaces (103), the values of the two abscissae corresponding to the maximum value divided by 10 of axial stress $Smzz$, where contact length $Lc$ is equal to the difference between said values of the two abscissae.

10. A device (1000) for estimating the tightness of a seal (9), including means (100, 200) able to implement a method for estimating the tightness of a seal (9) according to one of the previous claims.

11. A computer program product recording an executable code for the implementation of a method for estimating the tightness of a seal (9) according to one of claims 1 to 9.

**FIG.1**

**FIG.2**

FIG.3

FIG.4

FIG.5

FIG.6

FIG.7

FIG.8

FIG.9

FIG.10

FIG.11

FIG.12

FIG.13

FIG.14

FIG.15

FIG.16

FIG.17

FIG.18

FIG.19

FIG.20

## RÉFÉRENCES CITÉES DANS LA DESCRIPTION

### Littérature non-brevet citée dans la description

- **H. ZERRES.** Present calculation methods dedicated to bolted flanged connections. *International Journal of Pressure Vessels and Piping,* vol. 81, 211-216